# EUROPEAN PATENT APPLICATION

(11) **EP 4 797 881 A1**
(43) Date of publication of application: **26.08.2026**
(21) Application number: 24895480.2
(22) Date of filing: 27.05.2024
(51) Int. Cl.: H05H 7/04, H01J 37/317

(54) **SEGMENTED RADIO-FREQUENCY ACCELERATION SYSTEM, AND ION IMPLANTER**

(30) Priority: 27.11.2023 CN 202311588852
(71) Applicant: Qingdao SRI Intellectual Technology Co., Ltd., Qingdao, Shandong 266000 (CN)
(72) Inventor: NIE, Xiang, Beijing Road, China (Shandong) Pilot Free Trade Zone Qingdao Area Qingdao, Shandong 266000 (CN); CHEN, Xianglong, Beijing Road, China (Shandong) Pilot Free Trade Zone Qingdao Area Qingdao, Shandong 266000 (CN); SONG, Yunyang, Beijing Road, China (Shandong) Pilot Free Trade Zone Qingdao Area Qingdao, Shandong 266000 (CN); ZHU, Jungao, Beijing Road, China (Shandong) Pilot Free Trade Zone Qingdao Area Qingdao, Shandong 266000 (CN)
(74) Representative: Bergenstråhle & Partners AB
(86) International application number: PCT/CN2024/095450
(87) International publication number: WO 2025/112370

(57) **Abstract**

The present invention discloses a segmented radio frequency acceleration system and an ion implanter. The segmented radio frequency acceleration system comprises multiple radio frequency acceleration units and an achromatic deflection magnet system, wherein the achromatic deflection magnet system is arranged between two adjacent radio frequency acceleration units; and the achromatic deflection magnet system comprises one or more achromatic deflection magnets with non-uniform magnetic field distribution. The ion implanter comprises an ion source, an extraction device, a mass analysis magnet, the segmented radio frequency acceleration system, an energy analysis magnet, a focusing device, a scanner, and a parallelization magnet which are arranged in sequence. The present invention utilizes the achromatic deflection magnet system in conjunction with multiple radio frequency acceleration units to achieve segmented radio frequency acceleration of ion beams, meanwhile to achieve achromaticity and angular deflection to ensure that the ion beams move along a predetermined trajectory. During use, the overall shape of the segmented radio frequency acceleration system can be flexibly adjusted to save the space, thereby reducing the floor space of the ion implanter.

## Description

### BACKGROUND OF THE INVENTION

### 1. Technical Field

The present invention belongs to the technical field of semiconductors, and in particular, the present invention discloses a segmented radio frequency acceleration system and an ion implanter.

### 2. Description of Related Art

An ion implanter is one of the commonly used pieces of equipment in the field of semiconductor component manufacturing, having the main function of manipulating doped ions through various electrical and magnetic devices, and ultimately implanting into a substrate material to achieve material modification. With the increasing development of science and technology, the importance of ion implantation in the semiconductor field is increasingly prominent. The energy of implanted ions, the type of dopants, the doping depth, and the implantation angle are more precisely required, and the design of various components of ion implanters is also challengingly required.

High-energy ion implanters generally utilize radio frequency acceleration units to accelerate ions. Since a radio frequency acceleration voltage is a sinusoidal alternating voltage, the beam energy is modulated during the acceleration process, resulting in a continuous beam turning into a beam bunch with a certain energy dispersion. Furthermore, since a radio frequency acceleration section is a straight line segment, the ion implanter is fixed in shape and large in floor space.

### BRIEF SUMMARY OF THE INVENTION

### Technical problem to be solved:

The embodiment of the present invention provides a segmented radio frequency acceleration system and an ion implanter. An achromatic deflection magnet system is adopted in conjunction with multiple radio frequency acceleration units to achieve segmented radio frequency acceleration of ion beams, meanwhile to achieve achromaticity and angular deflection to ensure that the ion beams move along a predetermined trajectory. During use, the overall shape of the segmented radio frequency acceleration system can be flexibly adjusted to save the space, thereby reducing the floor space of the ion implanter. Meanwhile, the ion implanter is flexible and diverse in layout, solving the problems of beam energy dispersion after acceleration, as well as the fixed structure and large floor space of ion implanters.

### Technical solution

Therefore, the embodiment of the present invention provides the following technical solution:

The embodiment of the present invention provides a segmented radio frequency acceleration system, including multiple radio frequency acceleration units and an achromatic deflection magnet system, wherein the achromatic deflection magnet system is arranged between two adjacent radio frequency acceleration units; and the achromatic deflection magnet system includes one or more achromatic deflection magnets with non-uniform magnetic field distribution.

Furthermore, the angle of the achromatic deflection magnet system is 45-360 degrees.

Furthermore, the angles of multiple achromatic deflection magnets of the achromatic deflection magnet system are identical or different.

Furthermore, the numbers of radio frequency acceleration buckets in the multiple radio frequency acceleration units are identical or different.

The embodiment of the present invention also provides an ion implanter, including an ion source, an extraction device, a mass analysis magnet, the segmented radio frequency acceleration system of the embodiment, an energy analysis magnet, a focusing device, a scanner, and a parallelization magnet.

The ion source is used to generate ion beams.

The extraction device is arranged downstream of the ion source, and is used to extract the ion beams.

The mass analysis magnet is arranged downstream of the extraction device, and is used for mass analysis of extracted ion beams and screening out desired ion types to be implanted.

The segmented radio frequency acceleration system is arranged downstream of the mass analysis magnet, and is used for radio frequency acceleration and achromatic deflection of screened ion beams.

The energy analysis magnet is arranged downstream of the segmented radio frequency acceleration system, and is used for energy analysis of ion beams after radio frequency acceleration and achromatic deflection.

The focusing device is arranged downstream of the energy analysis magnet, and is used to focus ion beams after energy analysis.

The scanner is arranged downstream of the focusing device, and is used to scan focused ion beams along a preset direction at a preset scanning frequency.

The parallelization magnet is arranged downstream of the scanner, and is used to parallelize scanned ion beams.

Furthermore, the angle of the mass analysis magnet is 30-180 degrees.

Furthermore, the angle of the energy analysis magnet is 30-180 degrees.

Furthermore, the angle of the parallelization magnet is 30-180 degrees.

### Beneficial Effects

The present invention has the beneficial effects that: the achromatic deflection magnet system is used in conjunction with multiple radio frequency acceleration units to achieve segmented radio frequency acceleration of ion beams, meanwhile to achieve achromaticity and angular deflection to ensure that the ion beams move along a predetermined trajectory. During use, the overall shape of the segmented radio frequency acceleration system can be flexibly adjusted to save the space, thereby reducing the floor space of the ion implanter. And meanwhile, the ion implanter is flexible and diverse in layout.

### BRIEF DESCRIPTION OF DRAWINGS

In order to describe the technical solutions in the embodiments of the present invention more clearly, a brief description of the accompanying drawings required for describing the embodiments will be provided below. Obviously, the accompanying drawings in the following description show merely some embodiments of the present invention. Those of ordinary skill in the art can also derive other accompanying drawings from these accompanying drawings without making creative efforts.
FIG. 1 is a structural schematic diagram of an ion implanter of an embodiment of the present invention;
FIG. 2 is a structural schematic diagram of an ion implanter of another embodiment of the present invention;
FIG. 3 is a structural schematic diagram of an ion implanter of another embodiment of the present invention;
FIG. 4 is a structural schematic diagram of an ion implanter of another embodiment of the present invention;
FIG. 5 is a simulation diagram of ion beam deflection by an achromatic deflection magnet system in an embodiment of the present invention; and
FIG. 6 is a simulation diagram of ion beam deflection by an achromatic deflection magnet system in another embodiment of the present invention.

In the figures, 1, segmented radio frequency acceleration system; 11, radio frequency acceleration unit; 12, achromatic deflection magnet system; 13, achromatic deflection magnet; 2, ion source; 3, extraction device; 4, mass analysis magnet; 5, energy analysis magnet; 6, focusing device; 7, scanner; 8, parallelization magnet; 9, target chamber; and 10, quadrupole.

### DETAILED DESCRIPTION OF THE EMBODIMENTS

The technical solution of a segmented radio frequency acceleration system and an ion implanter provided in the present invention will be clearly and completely described below in conjunction with the accompanying drawings. Apparently, the described embodiments are only some of the embodiments of the present invention, but not all of the embodiments. On the basis of the embodiments in the present invention, all other embodiments obtained by those of ordinary skill in the art without creative efforts shall fall within the protection scope of the present invention.

In the description of the present invention, it should be understood that the terms "center", "longitudinal direction", "transverse direction", "length", "width", "thickness", "up", "down", "front", "back", "left", "right", "vertical", "horizontal", "top", "bottom", "inside", "outside", and other directional or positional relationships refer to the orientation or position relationships shown in the accompanying drawings, are used only for the purpose of describing and simplifying the description of the present invention, do not indicate or imply that the apparatus or component referred to must have a specific orientation, be constructed and operated in a particular orientation, and therefore should not be understood as limitations on the present invention. In addition, the terms "first", "second" and "third" are merely used for description purposes and cannot be interpreted as indicating or implying relative importance or implicitly indicating the number of technical features indicated. Thus, a feature defined as "first", "second" or "third" may explicitly or implicitly include one or more such features. In the description of the embodiments of the present invention, "multiple" means two or more, unless otherwise specifically defined.

In the embodiments of the present invention, unless otherwise clearly specified and limited, the terms "installed", "connected", "connection", "fixed", etc. should be understood broadly. For example, the "connection" may be a fixed connection, a detachable connection, or an integrated connection, may be a mechanical connection or an electrical connection, may be a direct connection or an indirect connection by means of an intermediate medium, or may be an internal connection of two elements or an interaction between two elements, unless otherwise clearly defined. Those of ordinary skill in the art can understand the specific meanings of the above terms in the embodiments of the present invention according to specific situations.

In the embodiments of the present invention, the term "exemplary" is used to indicate "serving as an example, illustration, or demonstration." Any embodiment described as "exemplary" in the embodiments of the present invention is not necessarily construed as being more preferred or advantageous than other embodiments. The following description is provided to enable any skill in the art to implement and utilize the embodiments of the present invention. In the following description, details are listed for the embodiments of the present invention for explanatory purposes. It should be understood that those of ordinary skill in the art can recognize that the embodiments of the present invention can be implemented even without using these specific details. In other examples, well-known structures and processes will not be elaborated in detail to avoid unnecessary details that may obscure the description of the embodiments of the present invention. Therefore, the embodiments of the present invention are not intended to be limited to the embodiments shown, but should be consistent with the broadest scope that conforms to the principles and features disclosed in the embodiments of the present invention.

### Embodiment I:

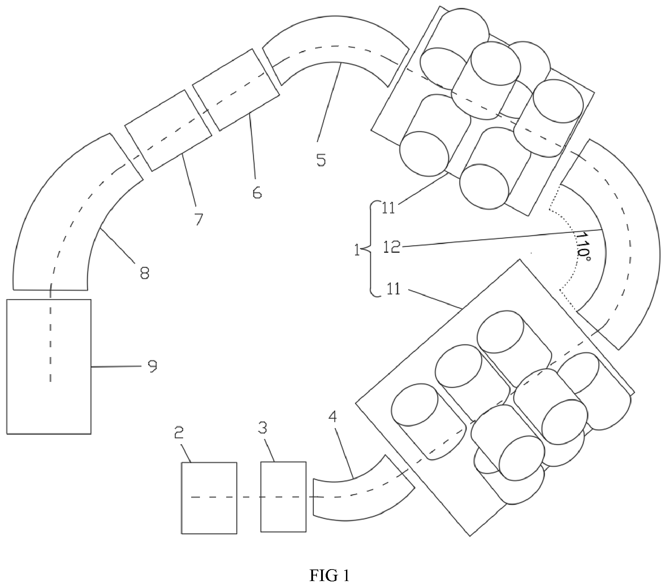

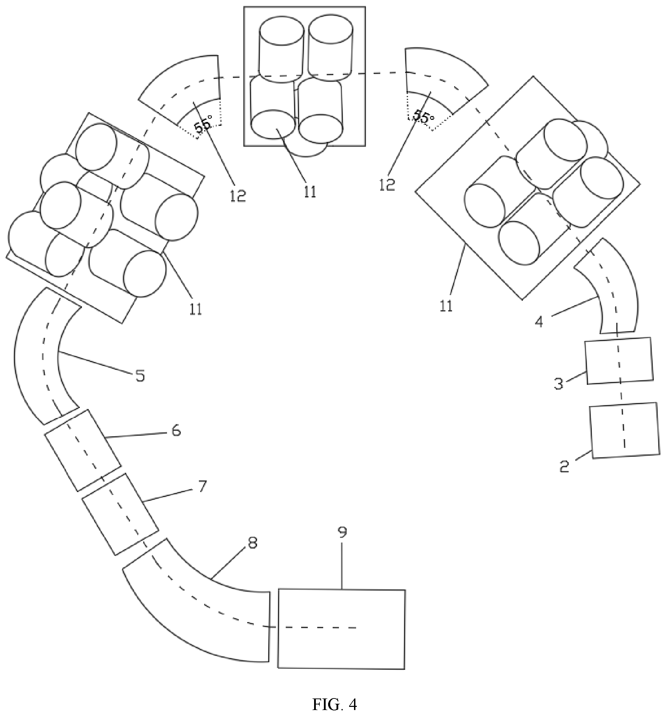

Refer to FIG. 1 to 4. The embodiment of the present invention provides a segmented radio frequency acceleration system, including multiple radio frequency acceleration units 11 and an achromatic deflection magnet system 12, wherein the achromatic deflection magnet system 12 is arranged between two adjacent radio frequency acceleration units 11. The multiple radio frequency acceleration units 11 inevitably cause energy dispersion. The achromatic deflection magnet system 12 arranged between every two radio frequency acceleration units 11 can achieve ion beam trajectory deflection while reducing the degree of energy dispersion and minimizing lateral beam loss. Due to the deflection by the achromatic deflection magnet system, the radio frequency acceleration system is no longer linear but can be deflected, allowing the shape to be flexibly adjusted and reducing the floor space. As shown in FIG.1 to 3, the segmented radio frequency acceleration system is equipped with two radio frequency acceleration units 11, and an achromatic deflection magnet system 12 is arranged between every two radio frequency acceleration units 11. As shown in FIG. 4, the segmented radio frequency acceleration system is equipped with three radio frequency acceleration units 11 and two achromatic deflection magnet systems 12, and an achromatic deflection magnet system 12 is arranged between every two radio frequency acceleration units 11.

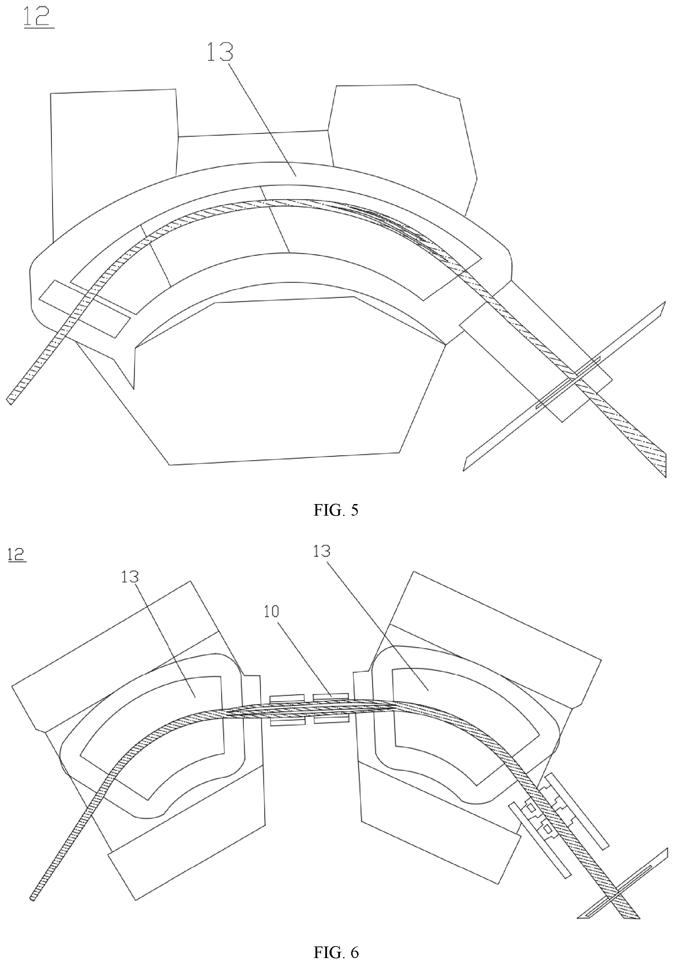

In the embodiment, the achromatic deflection magnet system 12 includes one or more achromatic deflection magnets 13 with non-uniform magnetic field distribution. That is, the achromatic deflection magnet system 12 can be a single magnet system or a multi-magnet system, depending on the specific requirements for deflection and achromaticity. The achromatic deflection magnet system 12 shown in FIG. 5 includes one 110-degree achromatic deflection magnet 13, while the achromatic deflection magnet system 12 shown in FIG. 6 includes two 55-degree achromatic deflection magnets 13, forming a composite field dual-magnet system. The two 55-degree achromatic deflection magnets 13 are connected in series, with two quadrupoles 10 placed therebetween, which can also achieve 110-degree deflection. Alternatively, a combination of 40-degree+40-degree+30-degree can be used, or other angle combinations can be adopted to achieve different layouts. To achieve a certain angle of deflection in the embodiment, one deflection magnet of that angle can be used, or multiple deflection magnets connected in series with a total deflection angle of that degree can be adopted.

The achromatic deflection magnet 13 is a magnet with non-uniform magnetic field distribution. Due to the inevitable energy dispersion produced by multiple radio frequency acceleration units 11, for general deflection magnets, ion beams with different energies have different deflection trajectories in a magnetic field. A conventional uniform field dipole magnet system adopted for ion beam trajectory deflection can result in significant beam loss due to energy dispersion. In the embodiment, the achromatic deflection magnet system 12 adopts a single magnet system with non-uniform magnetic field distribution or a composite field multi-magnet system, thereby further reducing the degree of energy dispersion and ensuring that the lateral beam loss is not significant during deflection.

The magnetic pole shape of the magnet with non-uniform magnetic field distribution in the embodiment of the present application is a quadric surface, preferably a hyperbola, and the magnetic field is divided into three sections, with each section accounting for 1/3. The variation gradient of the magnetic field in the middle section is opposite to the variation gradients of the front and rear sections.

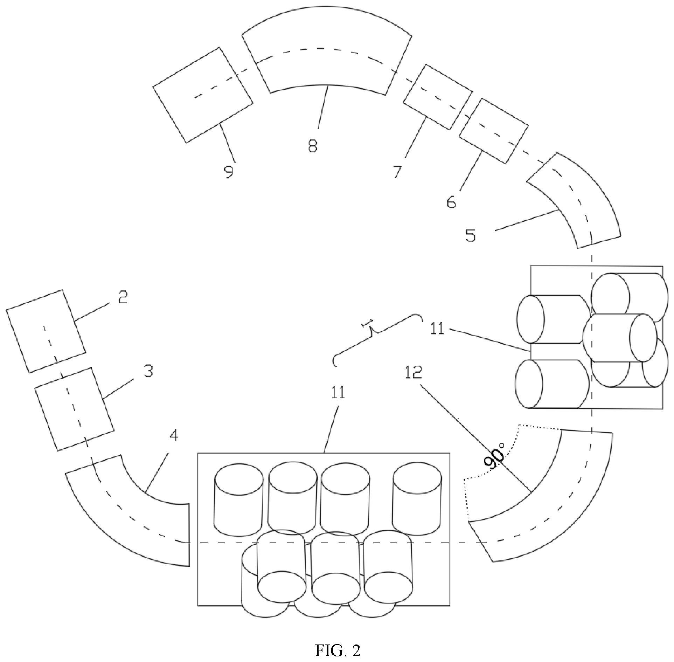

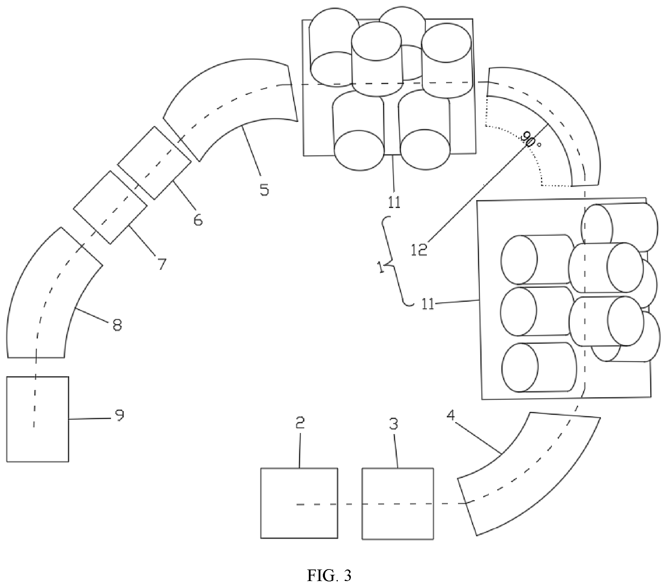

In the embodiment, the achromatic deflection magnet system 12 has an angle ranging from 45-360 degrees. Different deflection angles result in different bending angles of the achromatic deflection magnet system 12, leading to different overall shapes. Specific deflection angles can be flexibly adjusted according to actual production operation requirements and the size of an operation site. As shown in FIG. 1, the angle of the achromatic deflection magnet system 12 is 110 degrees. As shown in FIG. 2 and FIG. 3, the angle of the achromatic deflection magnet system 12 is 90 degrees. As shown in FIG. 4, the angles of the two achromatic deflection magnet systems 12 are both 55 degrees. Each achromatic deflection magnet system can be a single magnet system or a composite field multi-magnet system.

The angles of multiple achromatic deflection magnets 13 of the achromatic deflection magnet system 12 are identical or different. For example, the achromatic deflection magnet system 12 can use two 45-degree achromatic deflection magnets 13 to achieve a 90-degree deflection, or other combinations, such as three 30-degree achromatic deflection magnets 13, or one 30-degree achromatic deflection magnet 13 plus one 60-degree achromatic deflection magnet 13, as long as the total deflection angle is 90 degrees. The setting flexibility is improved, allowing for flexible options based on actual production needs and the size of the operation site.

The beam energy produced by general radio frequency acceleration is not unique and exhibits chromatic aberration. With conventional magnet deflection, a beam flow can be split into multiple beams, and subsequent radio frequency acceleration cannot be performed. In the embodiment, a composite magnetic field formed by the number of achromatic deflection magnets of the achromatic deflection magnet system and the design of the non-uniform magnetic field distribution of the magnets allows chromatically aberrated beams to be converged into one bunch after deflection, enabling subsequent radio frequency acceleration in a next stage.

Under a conventional deflection magnetic field, ion beams with different energies can spread out spatially during a later transmission stage, so a subsequent second-stage radio frequency acceleration cannot be performed. However, the achromatic deflection magnet system in the embodiment can effectively solve the problem and ensure that the ion beams before and after deflection by the achromatic deflection magnet system are close to, or almost identical to, each other in width. As shown in the simulation diagram of ion beam deflection in FIG. 5, the achromatic deflection magnet system includes an achromatic deflection magnet, and the achromatic deflection magnet is a magnet with non-uniform magnetic field distribution. The magnetic field in FIG. 5 is divided into three sections. As shown in FIG. 5, the beam transmission efficiency with a ±5% energy spread is 92%. In the third magnetic field section, three beams with different energies, 1000 keV, 1050 keV and 950 keV, are dispersed in the magnetic field, but ultimately converge into one beam after deflection. The ion beams before and after deflection by the achromatic deflection magnet are almost identical to each other in width, allowing for radio frequency acceleration after the deflection. As shown in the simulation diagram of ion beam deflection in FIG. 6, the achromatic deflection magnet system includes two achromatic deflection magnets. The beam transmission efficiency with a ±5% energy spread is 96%. After deflection by a first achromatic deflection magnet, three beams with different energies of 1000 keV, 1050 keV, and 950keV are dispersed, but ultimately converge into one beam after deflection by a second achromatic deflection magnet. The ion beams before and after deflection by the achromatic deflection magnets are almost identical to each other in width, allowing for radio frequency acceleration after the deflection.

The number of the radio frequency acceleration units 11 in the segmented radio frequency acceleration system can be flexibly adjusted according to actual production operation requirements and the size of the operation site. In the embodiment, the numbers of radio frequency acceleration buckets in the multiple radio frequency acceleration units 11 are identical or different. Due to the multiple radio frequency acceleration units 11 and the achromaticity and deflection of the achromatic deflection magnet system 12, the number of radio frequency acceleration buckets for each radio frequency acceleration unit 11 can also be flexibly distributed, as long as the radio frequency acceleration requirements are met. In the embodiment, the number of radio frequency acceleration buckets in each radio frequency acceleration unit is not more than 10. As shown in FIG. 1, the number of radio frequency acceleration buckets in the first radio frequency acceleration unit 11 is 8, and the number of radio frequency acceleration buckets in the second radio frequency acceleration unit 11 is 6. As shown in FIG. 2, the number of radio frequency acceleration buckets in the first radio frequency acceleration unit 11 is 10, and the number of radio frequency acceleration buckets in the second radio frequency acceleration unit 11 is 5. As shown in FIG. 3, the number of radio frequency acceleration buckets in the first radio frequency acceleration unit 11 is 8, and the number of radio frequency acceleration buckets in the second radio frequency acceleration unit 11 is 6. As shown in FIG. 4, the number of radio frequency acceleration buckets in the first radio frequency acceleration unit 11 is 5, the number of radio frequency acceleration buckets in the second radio frequency acceleration unit 11 is 5, and the number of radio frequency acceleration buckets in a third radio frequency acceleration unit 11 is 6. By adjusting the number of RF acceleration buckets in each radio frequency acceleration unit 11, the overall beam performance indicators and beam bunching layout of the ion implanter can be further optimized.

Through the design of the achromatic deflection magnet system, the number of radio frequency acceleration buckets in the radio frequency acceleration unit can be reduced. The radio frequency acceleration energy is not unique, and the fewer radio frequency acceleration buckets, the greater the energy spread. For beam deflection with a large energy spread, great difficulties can be caused in downstream transmission. For a large number (more than 12) of radio frequency acceleration buckets, the energy spread produced by the beams is also small (1%), and the design of the deflection magnets is correspondingly lowly required. For the transmission of a beam with a large energy spread (5%) accelerated by 5-10 radio frequency acceleration buckets, downstream transmission poses greater difficulties, and conventional deflection magnets cannot meet the demand. However, the embodiment effectively solves the problem through the design of the achromatic deflection magnet system, ensuring that the number of the radio frequency acceleration buckets in each radio frequency acceleration unit is not more than 10, thereby reducing the floor space.

### Embodiment II:

Based on the same inventive concept as Embodiment I, refer to FIG. 1 to 4, the embodiment specifically provides an ion implanter, including an ion source 2, an extraction device 3, a mass analysis magnet 4, the segmented radio frequency acceleration system 1 of the embodiment above, an energy analysis magnet 5, a focusing device 6, a scanner 7, and a parallelization magnet 8.

The ion source 2 is used to generate ion beams, and the ion source 2 is capable of producing multivalent ions of boron, phosphorus, arsenic, argon, xenon, or nitrogen.

The extraction device 3 is arranged downstream of the ion source 2, and is used to extract the ion beams.

The mass analysis magnet 4 is arranged downstream of the extraction device 3, and is used for mass analysis of extracted ion beams and screening out desired ion types to be implanted, ensuring the purity of the ion types, meanwhile playing a partial focusing role on transmitted ion beams, and increasing the beam transmission efficiency.

The segmented radio frequency acceleration system 1 is arranged downstream of the mass analysis magnet 4, and is used for radio frequency acceleration and achromatic deflection of screened ion beams, and meanwhile for reducing the floor space.

The energy analysis magnet 5 is arranged downstream of the segmented radio frequency acceleration system 1, and is used for energy analysis of ion beams after radio frequency acceleration and achromatic deflection.

The focusing device 6 is arranged downstream of the energy analysis magnet 5, and is used to focus ion beams after energy analysis, for the control of the size of the ion beams, and for shaping the ion beams into a desired cross-sectional profile. In the embodiment, the focusing device is a quadrupole lens.

The scanner 7 is arranged downstream of the focusing device 6, and is used to scan focused ion beams along a preset direction at a preset scanning frequency. The scanner 7 is a deflection scanning device that performs periodic reciprocal scanning of the ion beams in a horizontal direction orthogonal to the traveling direction of the ion beams, through a periodically varying electric field.

The parallelization magnet 8 is arranged downstream of the scanner 7, and is used to parallelize the scanned ion beams and adjust the deflected ion beams so as to align with the direction of the ion beams before scanning. That is, deflected ion beams are bent back to be parallel to a preset reference trajectory of the ion beams. Finally, the ion beams enter the target chamber 9.

In the embodiment, the angle of the mass analysis magnet 4 is 30-180 degrees. The angle of the energy analysis magnet 5 is 30-180 degrees. The angle of the parallelization magnet 8 is 30-180 degrees. The angles of the mass analysis magnet 4, the energy analysis magnet 5, and the parallelization magnet 8 can be flexibly adjusted according to production operation requirements and the size of the operation site. While own functions are met, the floor space of the ion implanter is reduced, and the ion implanter is flexible and diverse in layout.

Compared to the ion implanter shown in FIG. 1 to 4, the overall floor space of the ion implanter can be adjusted by flexibly adjusting the angles of the mass analysis magnet 4, the energy analysis magnet 5, the parallelization magnet 8, and the achromatic deflection magnet system 12, and can be flexibly adjusted according to actual production operation requirements and the size of the operation site, being good in applicability.

The ion implanter in the embodiment is also equipped with a controller and a software operating system, as well as a wafer transfer system that meets the requirements of the ion implantation process, for operators to input required conditions, perform numerical calculations of parameters based on the input conditions, and further control constituent elements. The controller and the software operating system adopt commonly used control methods and software operating systems in the field, which are not further elaborated here.

According to the embodiment, by adopting the segmented radio frequency acceleration system 1, the floor space of the ion implanter can be reduced, and due to the angular design of the mass analysis magnet 4, the energy analysis magnet 5 and the parallelization magnet 8, the floor space of the ion implanter is further reduced, and the ion implanter is flexible and diverse in layout.

The above descriptions are only preferred embodiments of the present invention, and are not intended to limit the present invention. Any modifications, equivalent replacements, simple improvements etc. made within the substantive content of the present invention shall be included in the protection scope of the present invention.

## Claims

1. A segmented radio frequency acceleration system, comprising multiple radio frequency acceleration units (11) and an achromatic deflection magnet system (12), wherein the achromatic deflection magnet system (12) is arranged between two adjacent radio frequency acceleration units (11); and the achromatic deflection magnet system (12) comprises one or more achromatic deflection magnets (13) with non-uniform magnetic field distribution.

2. The segmented radio frequency acceleration system according to claim 1, **characterized in that** the angle of the achromatic deflection magnet system (12) is 45-360 degrees.

3. The segmented radio frequency acceleration system according to claim 1, **characterized in that** the angles of multiple achromatic deflection magnets (13) of the achromatic deflection magnet system (12) are identical or different.

4. The segmented radio frequency acceleration system according to claim 1, **characterized in that** the numbers of radio frequency acceleration buckets in the multiple radio frequency acceleration units (11) are identical or different.

5. An ion implanter, comprising an ion source (2), an extraction device (3), a mass analysis magnet (4), a segmented radio frequency acceleration system (1) according to any one of claims 1 to 4, an energy analysis magnet (5), a focusing device (6), a scanner (7), and a parallelization magnet (8); wherein
the ion source (2) is used to generate ion beams;
the extraction device (3) is arranged downstream of the ion source (2), and is used to extract the ion beams;
the mass analysis magnet (4) is arranged downstream of the extraction device (3), and is used for mass analysis of extracted ion beams and screening out desired ion types to be implanted;
the segmented radio frequency acceleration system (1) is arranged downstream of the mass analysis magnet (4), and is used for radio frequency acceleration and achromatic deflection of screened ion beams;
the energy analysis magnet (5) is arranged downstream of the segmented radio frequency acceleration system (1), and is used for energy analysis of ion beams after radio frequency acceleration and achromatic deflection;
the focusing device (6) is arranged downstream of the energy analysis magnet (5), and is used to focus ion beams after energy analysis;
the scanner (7) is arranged downstream of the focusing device (6), and is used to scan focused ion beams along a preset direction at a preset scanning frequency; and
the parallelization magnet (8) is arranged downstream of the scanner (7), and is used to parallelize scanned ion beams.

6. The ion implanter according to claim 5, **characterized in that** the angle of the mass analysis magnet (4) is 30-180 degrees.

7. The ion implanter according to claim 5, **characterized in that** the angle of the energy analysis magnet (5) is 30-180 degrees.

8. The ion implanter according to claim 5, **characterized in that** the angle of the parallelization magnet (8) is 30-180 degrees.
